Europäisches Patentamt

European Patent Office

Office européen des brevets

(19)

(11) **EP 0 935 258 A1**

(12) **EUROPEAN PATENT APPLICATION**

(43) Date of publication:
**11.08.1999 Bulletin 1999/32**

(51) Int. Cl.$^6$: **G21C 17/06**, G01N 29/04

(21) Application number: **99101653.6**

(22) Date of filing: **05.02.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **09.02.1998 US 21028**

(71) Applicant:
**Siemens Power Corporation
Richland, WA 99352-0130 (US)**

(72) Inventor: **McClelland, Richard G.
Richland, WA 99352 (US)**

(74) Representative:
**Kahlhöfer, Hermann, Dipl.-Phys.
Patent- und Rechtsanwälte
Bardehle,Pagenberg,Dost,Altenburg,
Geissler,Isenbruck
Uerdinger Str. 5
40474 Düsseldorf (DE)**

(54) **Method for the inspection of nuclear fuel rod for fretting and wear within a nuclear fuel assembly**

(57) Method and apparatus for ultrasonic inspection of a nuclear fuel rod having an inner core of nuclear fuel surrounded by a cladding tube having a wall thickness into which is transmitted ultrasonic guided waves and from which is detected a reflected ultrasonic wave which is indicative of a variation of the wall thickness.

EP 0 935 258 A1

Printed by Xerox (UK) Business Services
2.16.7/3.6

## Description

### Field Of The Invention

The present invention relates generally to a method for ultrasonic inspection of the nuclear fuel rods in an array within a nuclear fuel assembly to detect flaws, damage, or wear of the nuclear fuel rod cladding tube.

The present invention relates to method utilizing ultrasonics for the detection of worn or damaged nuclear fuel rods within a nuclear fuel assembly, and more particularly to a method of transmitting ultrasonic waves into the fuel rod cladding of nuclear fuel rods and detecting a reflected wave from the fuel rod cladding tube.

### Background Of The Invention

The majority of nuclear power reactors are water cooled and moderated reactors, utilizing enriched uranium dioxide as fuel. The core of the reactor is formed by elongated fuel rods which are grouped into bundles known as fuel assemblies which are generally rectangular in cross section. The fuel rods have diameters usually in the range of one fourth to one half inch and are frequently longer than ten feet. Each fuel rod is formed of a cladding tube typically made of a zirconium alloy which surrounds an inner core of nuclear fuel, typically uranium dioxide. Most commonly, the uranium dioxide is in the form of pellets which are placed within the cladding. The fuel rods are held in a parallel array and in closely spaced fixed positions from each other by spacer grids. Spacers grids typically have an egg-crate shape and each spacer cell includes dimples and/or springs to position a fuel rod so that the desired fuel rod to fuel rod spacing (i.e. fuel rod pitch) is maintained. The springs and dimples keep the fuel rods in their proper lateral positions. But, under the influence of radiation, the springs are prone to relax which can lead to undesirable changes in fuel rod pitch or it may cause gaps or spaces to develop between fuel rods and the springs and dimples which increases the likelihood that the rods and/or spacer grids will vibrate due to coolant flow. Such gaps, changes in fuel rod pitch, and vibration may lead to fuel rod wear commonly known as fuel rod fretting from spacer grid interaction, and can ultimately lead to a breach or a hole through the wall of the fuel cladding tube which encloses the enriched uranium dioxide. Such a breach or hole results in the fuel rod failure. The abrasion occurs at the contact point within the spacer between the spacer spring and the fuel rod for each spacer within the fuel assembly. Although all fuel rods in an assembly are susceptible to this type of abrasion, damage is most common in the fuel rods at the lowest spacer region.

After a fuel assembly has been exposed in the reactor for a given period of time, it is typically taken out, checked for failure and defects, repaired if necessary, and either returned to the reactor or sent to storage for ultimate disposition. If the fuel assembly is to be returned to the reactor, it is typically tested and checked for defective and failed fuel rods. These irradiated assemblies are highly radioactive and must be stored, handled, and inspected under water in order to remove heat caused by the decay of fission products as well as to provide protection to persons working with them.

The inspection of nuclear fuel rods, before failure, for surface defects, as contrasted to fuel rod failure where the cladding tube has been breached, is currently not conducted with ultrasonics because present methods do not permit ultrasonic interrogation of the known predominant failure locations and areas (i.e. spacer locations) without the disassembly of the fuel assembly which is extraordinarily time consuming.

Instead, the detection of fuel rod fretting wear must rely on either error prone visual inspection and/or eddy current examination. However, either visual inspection or eddy current examination requires the disassembly of the fuel assembly, and the removal of each fuel rod which is to be inspected from the fuel assembly. The small spacing, particularly within PWR fuel assemblies, between fuel rods, and between fuel rods and the guide tubes (e.g. 0.072 inch fuel rod to guide tube), and spacers, renders interior fuel rods virtually if not completely inaccessible to prior art visual and eddy current inspection apparatuses and techniques. Both visual inspection and eddy current inspection are particularly incapable of determining whether fuel rod fretting wear has occurred at those locations on the surface of the fuel rod in contact with the spacer grids of the fuel assembly without disassembly of the fuel assembly. After such removal and disassembly, each fuel rod is then available for visual inspection and/or eddy current inspection to determine whether fretting wear or a non-through wall defect exists, where it exists, and the extent of such wear or defect for each fuel rod. Such eddy current inspection for fuel rod fretting wear of the fuel rods of a fuel assembly requires 8-10 hours to perform for each fuel assembly.

There therefore exists a need for an inspection method which overcomes the above-stated disadvantages and which enables the rapid and efficient inspection of fuel rod cladding tubes of fuel rods to identify surface defects or wear, and particularly for spacer grid-to-fuel rod fretting, in any fuel rod in the fuel assembly without the need to disassemble the fuel assembly to obtain access to each fuel rod.

### Summary of the Invention

The present invention relates to a method for ultrasonic inspection of a nuclear fuel rod having a cladding tube surrounding an inner core of nuclear fuel, said cladding tube having a predetermined wall thickness extending between an inner wall and an outer wall, comprising the steps of transmitting ultrasonic guided waves in the cladding tube and detecting a reflected ultrasonic wave from the cladding tube which reflected ultrasonic wave is indicative of a variation from the predetermined wall thickness.

In another embodiment, a method is provided for ultrasonic inspection of a nuclear fuel rod in an array of nuclear fuel rods, said nuclear fuel rod having a cladding tube surrounding an inner core of nuclear fuel, said cladding tube having a predetermined wall thickness extending between an inner wall and an outer wall, comprising the steps of transmitting ultrasonic guided waves in the cladding tube and detecting a reflected ultrasonic wave from the cladding tube which reflected ultrasonic wave is indicative of a variation from the predetermined wall thickness.

In another embodiment, a method is provided for ultrasonic inspection of nuclear fuel rod in a nuclear fuel assembly having an array of spaced apart parallel nuclear fuel rods, the nuclear fuel rod having a cladding tube surrounding an inner core of nuclear fuel, said cladding tube having a predetermined wall thickness extending between an inner wall and an outer wall, comprising the steps of transmitting ultrasonic guided waves in the cladding tube and detecting a reflected ultrasonic wave from the cladding tube which reflected ultrasonic wave is indicative of a variation from the predetermined wall thickness.

In another embodiment a method is provided for ultrasonic inspection of a cladding tube for a nuclear fuel rod, the cladding tube having a predetermined wall thickness extending between an inner wall and an outer wall, comprising the steps of transmitting ultrasonic guided waves in the cladding tube and detecting a reflected ultrasonic wave from the cladding tube which reflected ultrasonic wave is indicative of a variation from the predetermined wall thickness.

## Brief Description of the Drawings

Figure 1 depicts the excitation of guided waves using an oblique incidence, longitudinal wave transducer on a plexiglass wedge;

Figure 2 depicts phase velocity dispersion curve for zircaloy tubing;

Figure 3 depicts group velocity dispersion curve for zircaloy tubing;

Figure 4A is a graphical representation of the phase velocity excitation zone when guided waves are induced by oblique incidence, longitudinal wave excitation;

Figure 4B is a graphical representation of the phase velocity excitation zone when guided waves are induced by a periodic distribution of normal excitations with the spatial period equaling the wavelength of the excited mode, the ["comb" method];

Figure 5 depicts the comb type excitation and the relationship between spatial period and wavelength;

Figure 6 shows the experimental testing results of a defective cladding tube;

Figure 7 shows the experimental testing results of another defective cladding tube;

Figure 8 shows the experimental testing results of another defective cladding tube; and

Figure 9 shows the experimental testing results of yet another defective cladding tube.

## Detailed Description

The present invention provides a method which permits the rapid inspection and testing of nuclear fuel rods within BWR (boiling water reactor) and PWR (pressurized water reactor) fuel assemblies to detect fretting wear of the cladding tubes of nuclear fuel rods caused by debris trapped within a spacer as well as by spacer fretting induced by coolant flow. The present invention permits rapid testing of all fuel rods in an assembly without removing rods for individual inspection.

The prior art methods of detecting and sizing fretting indications (fretting wear marks) is by removing each fuel rod from the assembly and using visual or eddy current inspection techniques. This is extremely time consuming, expensive, and results in radiation exposure to the inspectors.

In accordance with an aspect of the present invention, a method is provided for ultrasonic inspection of a nuclear fuel rod having a cladding tube surrounding an inner core of nuclear fuel, where the cladding tube has a predetermined wall thickness extending between an inner wall and an outer wall, comprising the steps of transmitting ultrasonic guided waves in the cladding tube and detecting a reflected ultrasonic wave from the cladding tube which is indicative of a variation from the predetermined wall thickness.

A guided wave is an ultrasonic wave induced in a thin walled object with such properties that permit the wave to stay within the boundaries of the material with little or no leakage to either surface. Guided waves can be induced in thin plate as well as in thin walled tubing. The production of guided waves in an object is controlled by the proper selection of transducer frequency, transducer incidence angle, test object material velocity, and material wall thickness. Since the wave is attenuated only by the material impedance, the waves can travel long distances with little attenuation.

There are several ways of inducing guided waves in an object. The two most used are oblique incidence angle transducer and specially designed transducers such as a "comb" transducer. In the first, a standard transducer is positioned at a predetermined angle to the test object and a wave injected. Since the transducer element is not in contact with the test object due to the incidence angle, a conducting medium such as plastic or water must be added to transfer the sound from the transducer element to the test object. This greatly increases the thickness of the transducer and effectively precludes its use within a fuel assembly because of the narrow rod to rod and rod to guide tube gaps discussed further below.

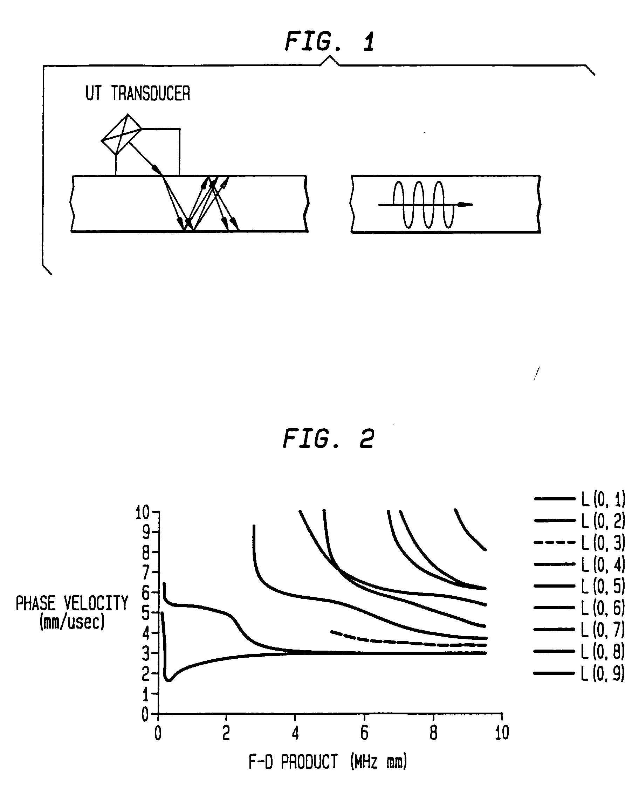

Referring to Figure 1, depicting the generation of a guided wave at an oblique incidence in a thin wall tube using a longitudinal wave transducer on an acoustic coupling material such as plastic. The longitudinal wave is incident at some incident angle $\Theta$, and velocity $V_{plexi}$. Due to Snell's law, the waves undergo mode conversion, reflection and refraction at the interfaces. At some distance away from the transducer, the waves will no longer be individually identifiable, but will superimpose into a wave packet.

For certain cases of incident angle, thickness, and material properties, constructive interference will take place, and a guided wave will propagate in the tube or plate. These conditions for constructive interference are met for many combinations of thickness, angle, and material properties. The combinations which result in constructive interference are termed modes. Each mode has its own characteristics of wave structure, propagation velocity, and stress distribution. In particular, each mode has an in plane and out of plane displacement at the wave guide surface. The amount of out of plane displacement dictates how "leaky" the mode will be since the out of plane displacement causes the generation of longitudinal waves out of the material and which carry energy out of the wave guide. This feature is particularly important in the application where the fuel rod has failed because a failed fuel rod tube will have water within it. Thus, for a failed or breached fuel rod, the selection of a leaky mode to the inner surface of the cladding tube will enable the detection of such failure since water will rapidly attenuate the sound field which is indicative of the presence of water. It is necessary to choose a non-leaky mode to both the inner and outer surface of the cladding tube for the inspection of a fuel rod which does not have a breached cladding tube.

The theoretical modeling of guided wave propagation results in dispersion curves and wave structure diagrams that describe the wave propagation. The phase velocity dispersion curve shown in Figure 2 is typically used for generation criterion for guided waves. In the case of oblique incidence generation, the phase velocity is simply related to angle of incidence by Snell's law:

$$\frac{Sin\theta_i}{V_{Plexi}} = \frac{Sin 90}{V_{Phase}}.$$

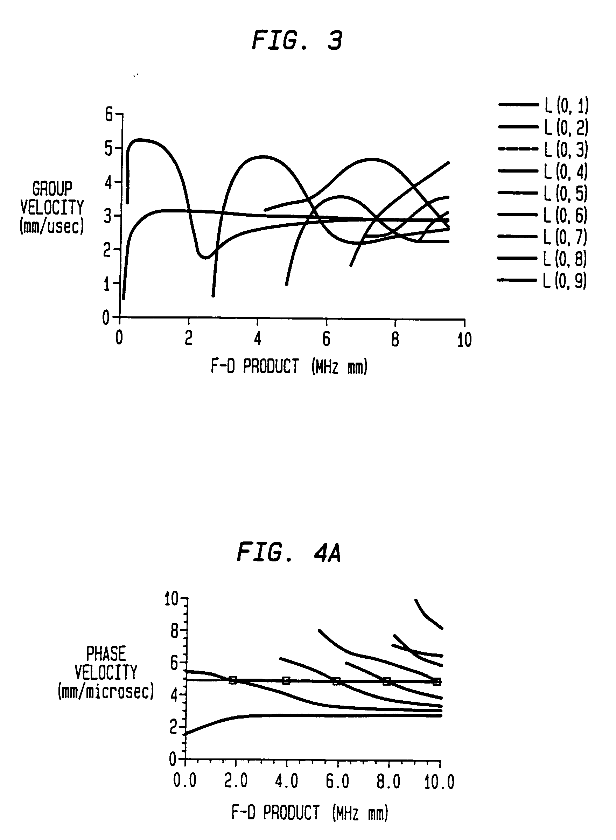

The group velocity dispersion curve is shown in Figure 3 and provides the propagation velocity of the generated guided waves modes.

As stated above, inducing guided waves by oblique incidence, longitudinal wave excitation is accomplished by coupling a longitudinal wave transducer to a fuel rod cladding tube at an incident angle through the use of a plastic wedge. A specific phase velocity is generated which is governed by Snell's Law for the plastic wedge. Therefore, modes can be generated which intercept the particular phase velocity excitation zone. Figure 4A shows the excitation zone for this method.

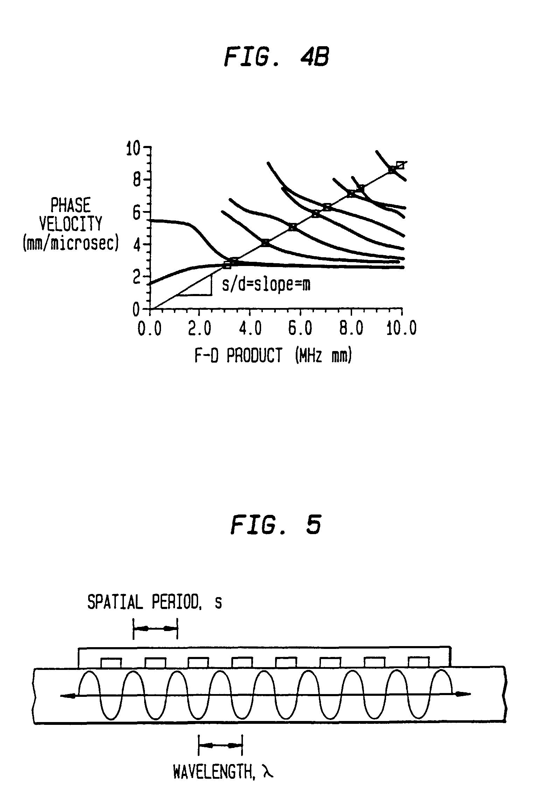

A second way of inducing guided waves in an object is the "comb" method. A comb transducer is a contact type transducer for producing guided waves and whose characteristics are determined by the spacing and thickness of the comb elements. In this method, excitation is accomplished by a periodic distribution of normal excitations with the spatial period equaling the wavelength of the excited mode (Figure 5). Instead of a horizontal excitation region as in the oblique incidence method (Fig. 4A), the excitation is in the form of a straight line passing through the origin (Fig. 4B). The equation of the line is of the form $y=mx$, where $y=V_{phase}$, $x=fd$ and $m=s/d$ and where

$$V_{phase} = f\lambda = fs = \frac{s}{d}\,fd,$$

and s is the comb spacing. Figure 4B is a graphical representation of the phase velocity excitation zone for this method.

Although either method of generation can be used for flaw detection such as a failure of the cladding tube by a breach, or fretting wear or defects, because comb transducers can be manufactured with a lower profile design, they provide means for obtaining access into the fuel assembly between the narrow spaces between fuel rods for generating guided waves in the cladding tubes of fuel rods within a fuel assembly without the need to disassemble the fuel assembly. Comb transducers can be manufactured with varying degrees of spacing and element thickness to generate the desired mode in a variety of material thicknesses and properties.

An advantage of a comb type of transducer is that it can be made relatively thin and still maintains its characteristics. Due to its small thickness, the comb transducer is the best practical method of introducing guided waves into fuel rods within an assembly. To test a fuel rod within an assembly, the transducer must pass between the small gaps (.072 inch or 1.9 mm fuel rod to guide tube) to test interior rods.

The comb transducer is designed to produce guided waves in the fuel rod cladding that have a longitudinal phase velocity that is "non-leaky" to both the fuel rod cladding tube inner surface and outer surface, i.e. the guided wave remains within the cladding wall. This provides for maximum sensitivity and minimum attenuation. The transducer operating frequency is selected to produce circumferential sound field intensities that are maximum at desired inspection points (normally at 135° to possible transducer presentation paths). Transducer parameters (operating frequency, distance between the "teeth" of the comb transducer, etc.) can be modified to cause the sound field to be at virtually desired any inspection point (i.e. axial position along the fuel rod).

In tubes, both axisymmetric and non-axisymmetric guided waves can propagate. Axisymmetric guided waves refer to modes where the particle motion is only in longitudinal and radial directions and have uniform distributions of stress and particle motion around the tube. This can be accomplished by using a fully encircling comb transducer. Non-axisymmetric guided waves have torsional components as well as longitudinal and radial components to the particle motion and have non-uniform distribution of stress and particular motion around the tube.

There are two inspection modes utilizing comb type transducers, "loaded" and "partially loaded". In a loaded application, the transducer fully surrounds the outer surface of the fuel rod (i.e. the outer surface) of the cladding tube (or the inner diameter for applications such as in steam generator tubes). This is the optimum test in that the transducer generates a uniform (axisymmetric) sound field that travels in both directions (i.e. axially and circumferentially) in the tube and gives the maximum sensitivity. In a partially loaded test, only a segment of the transducer contacts the test object. This is less than optimum in that it produces a non-axisymmetric sound field circumferentially and axially along the tube. This non-axisymmetric sound field has limited inspection value due to the nonuniformity of the sound field at any specific location. Because of the very limited access to the fuel rods within a nuclear fuel assembly, only partial loading sources can be used such as a section of a comb transducer which will product non-axisymmetric waves. This is not a problem because the transducer physical characteristics (e.g. number of comb teeth, loading area etc.) and fundamental frequency parameters can be optimized to generate the maximum sound field at the desired location. Changes to the location and intensity of the sound field are most sensitive to frequency changes.

In accordance with the present invention, the method of inspecting nuclear fuel rods to detect wear or defects in the fuel rod cladding comprises using a partially loaded, tone burst activated, comb transducer that is passed through the rod-to-rod gaps of a fuel assembly. By selecting the comb gaps and thickness, the transducer produces a field intensity at a specific axial and circumferential distance along the fuel rod. In a preferred embodiment, the circumferential distance could be selected to be at 90° to the sound entry point to account for the spring location relative to the available probe entry path.

Sound field characteristics are heavily dependent on frequency, when the properties of the test object are constant such as in nuclear fuel rod cladding tubes. To further increase the effectiveness of the inspection technique, the tone burst excitation would be "swept" through a specific frequency band causing the sound field to change in intensity circumferentially around the fuel rod being inspected. The use of a swept frequency tone burst generator as a transducer excitation source permits the entire region of the fuel rod within the spacer cell to be inspected from one location without the need for generating axisymmetric waves from a fully encircling comb transducer. Use of such a fully encircling comb transducer would require the disassembly of the fuel assembly in order to place the fuel rod through the encircling comb transducer. Defects within the fuel rod cladding would reflect part of the guided wave signal which would be received by the comb transducer operating in the pulse-echo mode. The amplitude of the reflected signal is proportional to the facial area of the defect. Thus, the use of swept frequency would permit the sound field to inspect a full 360° of the fuel rod by the sound field changing in accordance with the sweep frequency.

In another preferred embodiment of the present invention, the comb transducer is inserted into the spaces between the fuel rods, at a specified distance above or below a spacer. The transducer would be pulsed at a repetition rate. When the transducer achieved a position normal to the fuel rod, maximum loading will be achieved on a fuel rod, the injected signal would travel up and down the fuel rod, producing sound field intensities at the desired inspection point(s) as determined by the transducer physical characteristics. Because the guided wave produced in the fuel rod cladding tube is non-leaky, it is most sensitive to wear, defects or other changes in only the cladding wall. Portions of the sound wave are reflected for example by any change in the wall-to-wall thickness such as would be produced by a fretting mark. The reflected signal is received by the transmitting transducer and transmitted to and processed by the ultrasonic instrument. The transducer would then continue to be positioned through the assembly while data was gathered from each fuel rod. Each fuel rod in the assembly is inspected in this manner.

In accordance with another aspect of the present invention, a method for the detection of nuclear fuel rod wear or fuel rod failure is provided for which utilizes a "comb" style ultrasonic transducer to produce guided waves; an ultrasonic tester; and a transducer positioning system. More specifically, the comb transducer is mounted on a delivery system, an X-Y table positions the transducers within the fuel assembly, and an ultrasonic flaw detector receives and displays the ultrasonic signal received from the fuel rod. A sweep frequency generator drives the transducer, and a power amplifier amplifies the output of the sweep frequency generator.

The guide wave ultrasonic transducer can be either tone burst or shock excitation.

Some of the advantages of the method of the present invention over the prior art are:

1. Each fuel rod within an assembly can be inspected without disassembly;

2. All fuel rods within an assembly can be inspected in approximately 10 minutes as compared to 8 to 10 hours (manual disassembly and eddy current inspection of the fuel rods of the assembly);

3. Defects or wear as shallow as 0.007 inch can be detected;

4. The process of the present invention does not require the disassembly or handling of irradiated fuel rods;

5. No other application is swept frequency tone burst modulation used to move the sound field by design.

## Test Results

Experiments were carried out using a tone burst system and variable angle transducer to generate non-axisymmetric guided waves in fuel rod tube samples. The tone burst system provides a high voltage, gated, sinusoidal pulse that fires the transducer with a narrow frequency spectrum. The narrow spectrum is particularly important in that it allows the selection of single modes from the dispersion curves. The frequency of the transducer can be changed such that different portions of the dispersion curve can be excited.

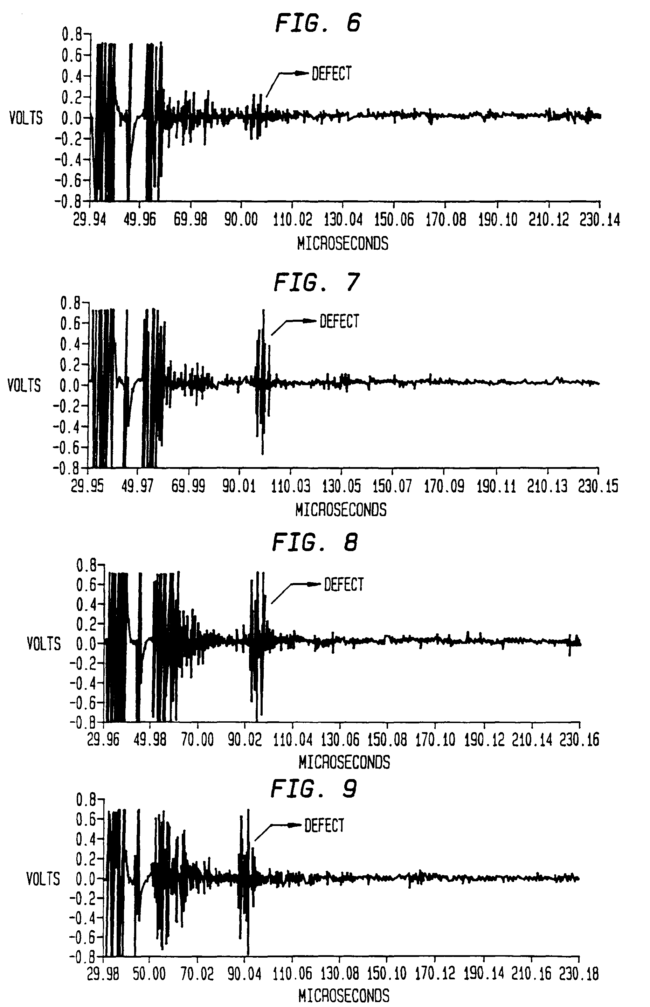

In these test, segments of nuclear fuel rod cladding tubes having defects, marring, or wear (without nuclear fuel) were plugged at either one or both ends and submersed in a water bath. Modes were chosen by an experimental and theoretical basis from the dispersion curves. A mode with sensitivity to all defect samples and with adequate signal to noise ratio was determined by these tests. Initially, a 3rd order, non-axisymmetric mode at a frequency of 5.18 MHz was found with adequate sensitivity and signal to noise ratio to perform the inspection. Experimental results with the transducer at 3" and 0 degrees with respect to the defect position are shown in Figures 6 - 9. All defects were detected. Additionally, the Figure 8 waveform shows that the presence of the cladding tube in the spacer cell with the spring clip does not impair the ability to determine the presence of the defect. This is significant since the spring causing the wear will usually be present in such locations.

While the foregoing description and drawings represent the preferred embodiments of the present invention, it will be apparent to those skilled in the art that various changes and modifications may be made therein without departing from the true spirit and scope of the present invention.

## Claims

1. A method for ultrasonic inspection of a nuclear fuel rod having a cladding tube surrounding an inner core of nuclear fuel, said cladding tube having a predetermined wall thickness extending between an inner wall and an outer wall, comprising the steps of:

transmitting ultrasonic guided waves in the cladding tube;

detecting a reflected ultrasonic wave from the cladding tube which reflected ultrasonic wave is indicative of a variation from the predetermined wall thickness.

2. The method of claim 1 wherein the step of transmitting ultrasonic guided waves is from a comb transducer.

3. The method of claim 2 wherein the ultrasonic guided waves that are transmitted by the comb transducer are non-leaky to the cladding tube inner wall and cladding tube outer wall.

4. The method of claim 3 wherein the ultrasonic guided waves are non-axisymmetric.

5. The method of claim 4 wherein the ultrasonic guided waves are transmitted by a partially loaded comb transducer.

6. The method of claim 5 wherein the ultrasonic guided waves are transmitted by the comb transducer from a swept frequency tone burst signal.

7. The method of claim 6 wherein the step of detecting the reflected ultrasonic wave from the cladding tube is performed by an ultrasonic flaw detector.

8. The method of claim 7 wherein the cladding tube is immersed in a compressible fluid.

9. A method for ultrasonic inspection of a nuclear fuel rod in an array of nuclear fuel rods, said nuclear fuel rod having a cladding tube surrounding an inner core of nuclear fuel, said cladding tube having a predetermined wall thickness extending between an inner wall and an outer wall, comprising the steps of:

transmitting ultrasonic guided waves in the cladding tube;

detecting a reflected ultrasonic wave from the cladding tube which reflected ultrasonic wave is indicative of a variation from the predetermined wall thickness.

10. The method of claim 9 wherein the step of transmitting ultrasonic guided waves is from a comb transducer.

11. The method of claim 10 wherein the ultrasonic guided waves that are transmitted by the comb transducers are non-leaky to the cladding tube inner wall and cladding tube outer wall.

12. The method of claim 11 wherein the ultrasonic guided waves are non-axisymmetric.

13. The method of claim 12 wherein the ultrasonic guided waves are transmitted by a partially loaded comb transducer.

14. The method of claim 13 wherein the ultrasonic guided waves are transmitted by the comb transducer from a swept frequency tone burst signal.

15. The method of claim 14 wherein the step of detecting the reflected ultrasonic wave from the cladding tube is performed by an ultrasonic flaw detector.

16. The method of claim 15 wherein the cladding tube is immersed in a compressible fluid.

17. A method for ultrasonic inspection of nuclear fuel rod in a nuclear fuel assembly having an array of spaced apart parallel nuclear fuel rods, the nuclear fuel rod having a cladding tube surrounding an inner core of nuclear fuel, said cladding tube having a predetermined wall thickness extending between an inner wall and an outer wall, comprising the steps of: transmitting ultrasonic guided waves in the cladding tube; and detecting a reflected ultrasonic wave from the cladding tube which reflected ultrasonic wave is indicative of a variation from the predetermined wall thickness.

18. The method of claim 17 wherein the step of transmitting ultrasonic guided waves is from a comb transducer.

19. The method of claim 18 wherein the ultrasonic guided waves that are transmitted by the comb transducer are non-leaky to the cladding tube inner wall and cladding tube outer wall.

20. The method of claim 19 wherein the ultrasonic guided waves are non-axisymmetric.

21. The method of claim 20 wherein the ultrasonic guided waves are transmitted by a partially loaded comb transducer.

22. The method of claim 21 wherein the ultrasonic guided waves are transmitted by the comb transducer from a swept frequency tone burst signal.

23. The method of claim 22 wherein the step of detecting the reflected ultrasonic wave from the cladding tube is performed by an ultrasonic flaw detector.

24. The method of claim 23 wherein the cladding tube is immersed in a compressible fluid.

25. A method for ultrasonic inspection of a cladding tube for a nuclear fuel rod, the cladding tube having a predetermined wall thickness extending between an inner wall and an outer wall, comprising the steps of transmitting ultrasonic waves in the cladding tube; detecting a reflected ultrasonic wave from the cladding tube which reflected ultrasonic wave is indicative of a variation from the predetermined wall thickness.

26. The method of claim 25 wherein the step of transmitting ultrasonic guided waves is from a comb transducer.

27. The method of claim 26 wherein the ultrasonic guided waves that are transmitted by the comb transducer are non-leaky to the cladding tube inner wall and cladding tube outer wall.

28. The method of claim 27 wherein the ultrasonic guided waves are non-axisymmetric.

29. The method of claim 28 wherein the ultrasonic guided waves are transmitted by a partially loaded comb transducer.

30. The method of claim 29 wherein the ultrasonic guided waves are transmitted by the comb transducer from a swept frequency tone burst signal.

31. The method of claim 30 wherein the step of detecting the reflected ultrasonic guided wave from the cladding tube is performed by an ultrasonic flaw detector.

32. The method of claim 31 wherein the cladding tube is immersed in a compressible fluid.

33. Apparatus for ultrasonic inspection of a nuclear fuel rod having a cladding tube surrounding an inner core of nuclear fuel, said cladding tube having a predetermined wall thickness extending between an inner wall and an outer wall, comprising

means for transmitting ultrasonic guided waves in the cladding tube;

means for detecting a reflected ultrasonic wave from the cladding tube which reflected ultrasonic wave is indicative of a variation from the predetermined wall thickness.

34. The apparatus of claim 33 wherein the means for transmitting ultrasonic guided waves is a comb transducer.

35. The apparatus of claim 34 wherein the ultrasonic guided waves that are transmitted by the comb transducer are non-leaky to the cladding tube inner wall and cladding tube outer wall.

36. The apparatus of claim 35 wherein the ultrasonic guided waves are non-axisymmetric.

37. The apparatus of claim 36 wherein the ultrasonic guided waves are transmitted by a partially loaded comb transducer.

38. The apparatus of claim 37 wherein the ultrasonic guided waves are transmitted by the comb transducer from a swept frequency tone burst signal.

39. The apparatus of claim 38 wherein the means for detecting the reflected ultrasonic wave from the cladding tube is performed by an ultrasonic flaw detector.

40. The apparatus of claim 39 wherein the cladding tube is immersed in a compressible fluid.

41. An apparatus for ultrasonic inspection of a nuclear fuel rod in an array of nuclear fuel rods, said nuclear fuel rod having a cladding tube surrounding an inner core of nuclear fuel, said cladding tube having a predetermined wall thickness extending between an inner wall and an outer wall, comprising:

means for transmitting ultrasonic guided waves in the cladding tube;

means for detecting a reflected ultrasonic wave from the cladding tube which reflected ultrasonic wave is indicative of a variation from the predetermined wall thickness.

42. The apparatus of claim 42 wherein the means for transmitting ultrasonic guided waves is from a comb transducer.

43. The apparatus of claim 42 wherein the ultrasonic guided waves that are transmitted by the comb transducers are non-leaky to the cladding tube inner wall and cladding tube outer wall.

44. The apparatus of claim 43 wherein the ultrasonic guided waves are non-axisymmetric.

45. The apparatus of claim 44 wherein the ultrasonic guided waves are transmitted by a partially loaded comb transducer.

46. The apparatus of claim 45 wherein the ultrasonic guided waves are transmitted by the comb transducer from a swept frequency tone burst signal.

47. The apparatus of claim 46 wherein the means for detecting the reflected ultrasonic wave from the cladding tube is performed by an ultrasonic flaw detector.

48. The method of claim 47 wherein the cladding tube is immersed in a compressible fluid.

49. An apparatus for ultrasonic inspection of nuclear fuel rod in a nuclear fuel assembly having an array of spaced apart parallel nuclear fuel rods, the nuclear fuel rod having a cladding tube surrounding an inner core of nuclear fuel, said cladding tube having a predetermined wall thickness extending between an inner wall and an outer wall, comprising: means for transmitting ultrasonic guided waves in the cladding tube; and means for detecting a reflected ultrasonic wave from the cladding tube which reflected ultrasonic wave is indicative of a variation from the predetermined wall thickness.

50. The apparatus of claim 49 wherein the means for transmitting ultrasonic guided waves is from a comb transducer.

51. The apparatus of claim 50 wherein the ultrasonic guided waves that are transmitted by the comb transducer are non-leaky to the cladding tube inner wall and cladding tube outer wall.

52. The apparatus of claim 51 wherein the ultrasonic guided waves are non-axisymmetric.

53. The method of claim 52 wherein the ultrasonic guided waves are transmitted by a partially loaded comb transducer.

54. The method of claim 53 wherein the ultrasonic guided waves are transmitted by the comb transducer from a swept frequency tone burst signal.

55. The apparatus claim 54 wherein the step of detecting the reflected ultrasonic wave from the cladding tube is performed by an ultrasonic flaw detector.

56. The apparatus of claim 55 wherein the cladding tube is immersed in a compressible fluid.

57. An apparatus for ultrasonic inspection of a cladding tube for a nuclear fuel rod, the cladding tube having a predetermined wall thickness extending between an inner wall and an outer wall, comprising means for transmitting ultrasonic guided waves in the cladding tube and means for detecting a reflected ultrasonic wave from the cladding tube which reflected ultrasonic wave is indicative of a variation from the predetermined wall thickness.

58. The apparatus of claim 57 wherein the step of transmitting ultrasonic guided waves is from a comb transducer.

59. The apparatus of claim 58 wherein the ultrasonic guided waves that are transmitted by the comb transducer are non-leaky to the cladding tube inner wall and cladding tube outer wall.

60. The apparatus of claim 59 wherein the ultrasonic guided waves are non-axisymmetric.

61. The apparatus of claim 60 wherein the ultrasonic guided waves are transmitted by a partially loaded comb transducer.

62. The apparatus of claim 61 wherein the ultrasonic guided waves are transmitted by the comb transducer from a swept frequency tone burst signal.

63. The apparatus of claim 62 wherein the means for detecting the reflected ultrasonic wave from the cladding tube is performed by an ultrasonic flaw detector.

64. The apparatus of claim 63 wherein the cladding tube is immersed in a compressible fluid.

## *FIG. 1*

UT TRANSDUCER

## *FIG. 2*

PHASE VELOCITY (mm/usec)

F-D PRODUCT (MHz mm)

L (0, 1)
L (0, 2)
L (0, 3)
L (0, 4)
L (0, 5)
L (0, 6)
L (0, 7)
L (0, 8)
L (0, 9)

## FIG. 3

GROUP VELOCITY (mm/usec) vs F-D PRODUCT (MHz mm)

Legend: L (0, 1), L (0, 2), L (0, 3), L (0, 4), L (0, 5), L (0, 6), L (0, 7), L (0, 8), L (0, 9)

## FIG. 4A

PHASE VELOCITY (mm/microsec) vs F-D PRODUCT (MHz mm)

# FIG. 4B

PHASE VELOCITY (mm/microsec)

s/d=slope=m

F-D PRODUCT (MHz mm)

# FIG. 5

SPATIAL PERIOD, s

WAVELENGTH, λ

*FIG. 6*

*FIG. 7*

*FIG. 8*

*FIG. 9*

13

EP 0 935 258 A1

**European Patent Office**

**EUROPEAN SEARCH REPORT**

Application Number

EP 99 10 1653

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 684 493 A (GRAVELLE ALAIN) 4 August 1987 * abstract * * column 1, line 7-18 * * column 1, line 61-66 * * column 2, line 14-61 * * column 3, line 65 - column 4, line 16 * * column 4, line 36-63 * * column 5, line 16-30 * * column 6, line 31-65; figures 1,8-10 * | 1-64 | G21C17/06 G01N29/04 |
| X A | US 4 366 711 A (WEILBACHER JEAN-CLAUDE ET AL) 4 January 1983 * column 3, line 26 - column 4, line 68 * <br><br>* column 6, line 48-53 * | 1,25,33, 57 9,17,41, 49 | |
| X | DE 26 05 405 A (MANNESMANN AG) 11 August 1977 <br><br>* the whole document * | 1,9,17, 25,33, 41,49,57 | |
| A | US 4 193 843 A (JESTER ALFRED ET AL) 18 March 1980 <br><br><br><br><br><br>* column 2, line 10-26; figures 1-4 * * column 3, line 52 - column 4, line 42 * | 1,8,9, 16,17, 24,25, 32,33, 40,41, 48,49, 56,57,64 | TECHNICAL FIELDS SEARCHED (Int.Cl.6) G21C G01N |
| X A | PATENT ABSTRACTS OF JAPAN vol. 015, no. 384 (P-1258), 27 September 1991 & JP 03 154861 A (MITSUBISHI HEAVY IND LTD), 2 July 1991 * abstract * | 1,9,17, 25,33, 41,49,57 | |

The present search report has been drawn up for all claims

| Place of search | Date of completion of the search | Examiner |
|---|---|---|
| THE HAGUE | 21 May 1999 | Jandl, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

## ANNEX TO THE EUROPEAN SEARCH REPORT
## ON EUROPEAN PATENT APPLICATION NO.

EP 99 10 1653

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-1999

| Patent document cited in search report | | Publication date | Patent family member(s) | | Publication date |
|---|---|---|---|---|---|
| US 4684493 | A | 04-08-1987 | FR 2538155 A | | 22-06-1984 |
| | | | EP 0115231 A | | 08-08-1984 |
| | | | JP 1754680 C | | 23-04-1993 |
| | | | JP 4047798 B | | 04-08-1992 |
| | | | JP 59214793 A | | 04-12-1984 |
| | | | YU 244383 A | | 30-06-1991 |
| | | | ZA 8309194 A | | 30-01-1985 |
| US 4366711 | A | 04-01-1983 | FR 2454675 A | | 14-11-1980 |
| | | | EP 0018290 A | | 29-10-1980 |
| | | | JP 56000650 A | | 07-01-1981 |
| | | | ZA 8002361 A | | 29-04-1981 |
| DE 2605405 | A | 11-08-1977 | NONE | | |
| US 4193843 | A | 18-03-1980 | DE 2605962 A | | 18-08-1977 |
| | | | AT 360126 B | | 29-12-1980 |
| | | | AT 955976 A | | 15-05-1980 |
| | | | BE 851280 A | | 31-05-1977 |
| | | | CA 1091339 A | | 09-12-1980 |
| | | | CH 604324 A | | 15-09-1978 |
| | | | DE 2659555 A | | 06-07-1978 |
| | | | FR 2341183 A | | 09-09-1977 |
| | | | GB 1541761 A | | 07-03-1979 |
| | | | JP 1105973 C | | 30-07-1982 |
| | | | JP 52098894 A | | 19-08-1977 |
| | | | JP 56050239 B | | 27-11-1981 |
| | | | SE 434583 B | | 30-07-1984 |
| | | | SE 7701422 A | | 15-08-1977 |

EPO FORM P0459

For more details about this annex : see Official Journal of the European Patent Office, No. 12/82